(19) Europäisches Patentamt
European Patent Office
Office européen des brevets

(11) **EP 4 503 060 A1**

(12) **EUROPEAN PATENT APPLICATION**
published in accordance with Art. 153(4) EPC

(43) Date of publication:
**05.02.2025 Bulletin 2025/06**

(21) Application number: 23779150.4

(22) Date of filing: **28.02.2023**

(51) International Patent Classification (IPC):
*H01B 1/22* (2006.01)    *B22F 1/00* (2022.01)
*B22F 1/052* (2022.01)    *B22F 1/06* (2022.01)
*B22F 1/107* (2022.01)    *B22F 7/08* (2006.01)
*B22F 9/00* (2006.01)    *H01L 21/52* (2006.01)

(52) Cooperative Patent Classification (CPC):
**B22F 1/00; B22F 1/052; B22F 1/06; B22F 1/107;
B22F 7/08; B22F 9/00; H01B 1/22; H01L 21/52**

(86) International application number:
**PCT/JP2023/007403**

(87) International publication number:
**WO 2023/189120 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **31.03.2022 JP 2022059658**

(71) Applicant: **Mitsui Mining & Smelting Co., Ltd.
Shinagawa-ku
Tokyo 141-8584 (JP)**

(72) Inventors:
• **ANAI, Kei
Ageo-shi, Saitama 362-0021 (JP)**
• **NISHIKAWA, Jo
Ageo-shi, Saitama 362-0021 (JP)**

(74) Representative: **Novagraaf Technologies
Bâtiment O2
2, rue Sarah Bernhardt
CS90017
92665 Asnières-sur-Seine Cedex (FR)**

(54) **COPPER PASTE FOR PRESSURE BONDING, SEMICONDUCTOR DEVICE, METHOD FOR PREPARING COPPER PASTE FOR PRESSURE BONDING, AND METHOD FOR MANUFACTURING SEMICONDUCTOR DEVICE**

(57) Provided is a copper paste for pressure bonding, the copper paste at least containing two or more copper powders having different shapes and/or particle sizes and a solvent. The copper paste has a viscosity of 10 Pa·s or more and 200 Pa·s or less. The ratio of the total mass of the two or more copper powders to the mass of the copper paste, A, is 0.60 or more and less than 0.82. When the index of bulkiness, H, is defined as $H = C/(A \times B)$, H is 0.75 or more and 1.00 or less, wherein A is as defined above, B represents the film thickness of a coating film formed by applying the copper paste to a substrate, and C represents the film thickness of a dried coating film formed by drying the coating film in an air atmosphere at 110°C for 20 minutes.

EP 4 503 060 A1

## Description

Technical Field

The present invention relates to a copper paste for pressure bonding, a semiconductor device, a method for producing a copper paste for pressure bonding, and a method for producing a semiconductor device.

Background Art

In recent years, an electronic component called a power module has been used to achieve high efficiency and space savings of power semiconductor devices. A power module includes: a substrate; a plurality of semiconductor elements mounted on one side of the substrate; and a baseplate or a cooling member, such as and a heat sink, mounted on the other side. These constituent members are connected to each other via a bonding material, a heat conductive grease, or the like. Such power modules are required to have long-term reliability, and use of a sintered material obtained by sintering a metal such as silver or copper as a bonding material has gained attention as one of the approaches to long-term reliability. In order to obtain even higher bonding reliability, the sintered material is sometimes used in a pressure-bonding process.

On the other hand, semiconductor elements are becoming thinner and thinner every year. The reduction in thickness of semiconductor elements may lead to damage to the semiconductor elements caused by the pressure-bonding process and uneven bonding in which the semiconductor element is not uniformly bonded onto the bonding material. In addition, the bonding area between a substrate on which a semiconductor chip is mounted and a baseplate, a heat sink, or the like is large, and accordingly, uneven bonding as described above tends to occur.

To address these problems, the applicant of the present application previously proposed a composition for pressure bonding containing a metal powder and a solid reducing agent (see Patent Literature 1). According to this literature, the compressibility ((A-B)/A×100) falls within a specific range, wherein A represents the thickness of a dried coating film formed by drying the composition for pressure bonding in an air atmosphere and B represents the thickness of a sintered body formed by firing the dried coating film in a nitrogen atmosphere. This literature discloses that conductors to be bonded can be sufficiently bonded to each other via the composition under smaller influence of variations in thickness of the conductors.

Citation List

Patent Literature

Patent Literature 1: EP 3950185A1

Summary of Invention

In the field of power semiconductors, as members to be bonded (hereinafter also referred to as "bonding target member") become thinner and larger in area as described above, high reliability in bonding of these members is needed more than ever. When an existing bonding composition is used to bond such bonding target members, damage to semiconductor elements during bonding and uneven bonding will occur more distinctly than ever. For this reason, there is demand for a composition for bonding that delivers even better bonding performance than the bonding composition disclosed in Patent Literature 1.

Therefore, an object of the present invention is to provide a copper paste for pressure bonding which enables bonding with large strength without uneven bonding even when a member to be bonded is thin or has a large area.

The present invention provides a copper paste for pressure bonding, at least comprising: two or more copper powders having different shapes and/or particle sizes; and a solvent;

wherein the copper paste has a viscosity of 10 Pa·s or more and 200 Pa·s or less at 25°C,
A is 0.70 or more and less than 0.82, and
H is 0.75 or more and 1.00 or less,
wherein A represents a ratio of a total mass of the two or more copper powders to a mass of the copper paste, and H represents an index of bulkiness defined as H = C/(A×B),
wherein B represents a film thickness of a coating film formed by applying the copper paste to a member to be bonded, and
C represents a film thickness of a dried coating film formed by drying the coating film in an air atmosphere at 110°C for 20 minutes.

The present invention also provides a method for producing a copper paste for pressure bonding,

the method including: mixing two or more copper powders having different shapes and/or particle sizes, and a solvent, wherein the mixing step is regulated such that the copper paste has a viscosity of 10 Pa·s or more and 200 Pa·s or less at a shear rate of 10 s$^{-1}$, and

the mixing step is further regulated such that A is 0.70 or more and less than 0.82, and H is 0.75 or more and 1.00 or less,

wherein A represents a ratio of a total mass of the two or more copper powders having different shapes and/or particle sizes to a mass of the copper paste, and

H represents an index of bulkiness defined as H = C/(A×B),

wherein B represents a film thickness of a coating film formed by applying the copper paste to a member to be bonded, and

C represents a film thickness of a dried coating film formed by drying the coating film in an air atmosphere at 110°C for 20 minutes.

Description of Embodiments

Hereinafter, the present invention will be described by way of preferred embodiments thereof. The present invention relates to a copper paste used to bond two bonding target members to each other under pressure. The phrase "under pressure" as used herein means intentionally applying a pressure of 0.001 MPa or more to the bonding target members, from outside the members. Therefore, the application of pressure simply due to a pressure load caused by a change in atmospheric pressure or the self-weight of a member such as a bonding target member is not encompassed by the meaning of the phrase "under pressure" as used herein.

The term "copper powder" contained in the copper paste of the present invention encompasses both a pure copper powder and a copper-based alloy powder. The copper powder contained in the copper paste may be only a pure copper powder or a copper-based alloy powder, or may be a mixed powder composed of a pure copper powder and a copper-based alloy powder. The copper paste may contain a small amount of metal powder other than a copper powder as long as the advantageous effects of the present invention are not impaired.

The copper paste of the present invention preferably contains two or more copper powders having different shapes and/or particle sizes. There is no particular limitation on the shape of copper particles constituting the two or more copper powders, and the copper particles used may be spherical copper particles or non-spherical copper particles.

In a case where the two or more copper powders in the present invention contain two or more types of spherical copper particles, the two or more types of spherical copper particles are different in $D_{SEM50}$, which will be described later. In a case where the two or more copper powders contain two or more types of non-spherical copper particles, the two or more types of non-spherical copper particles are different in $D_{50}$, which will be described later. In a case where the two or more copper powders contain spherical copper particles and non-spherical copper particles, it is preferable that the $D_{SEM50}$ of the spherical copper particles and the $D_{50}$ of the non-spherical copper particles are within the respective ranges described later.

When copper particles are spherical, this means that the copper particles have a circularity coefficient of 0.85 or more as determined by the following method. The circularity coefficient is calculated using the following method. Specifically, a scanning electron microscope image of a primary particle of a copper particle is captured; the area and the perimeter length of the two-dimensional projection image of the copper particle are designated as S and L, respectively; and the circularity coefficient of the copper particle is calculated using the expression: $4\pi S/L^2$.

On the other hand, when copper particles are non-spherical, this means that the copper particles have a circularity coefficient of less than 0.85.

Specific examples of non-spherical shapes include a flat shape, a polyhedral shape such as a hexahedron or an octahedron, a spindle-like shape, and an irregular shape. In the present invention, any of the two or more copper powders are preferably flat copper particles, and the two or more copper powders more preferably contains flat copper particles and spherical copper particles as will be described later. The term "flat" as used herein refers to a shape that has a pair of planar surfaces as the major surfaces of the particle and a side surface orthogonal to the planar surfaces, and the planar surfaces and the side surface may each independently be a plane, a curved surface, or an uneven surface.

When flat copper particles are contained as a material constituting the two or more copper powders, breakage of a dried coating film or a sintered body formed of the copper paste of the present invention can be effectively suppressed. Also, the bulkiness of the dried coating film, which is obtained by drying the copper paste of the present invention applied to a bonding target member, can be increased. The advantages of increased bulkiness of the dried coating film will be described later.

When spherical copper particles are contained as a material constituting the two or more copper powders, the copper paste of the present invention has improved sinterability.

When a copper powder is composed of spherical copper particles, the particle size of the copper powder is defined as the cumulative volume particle size at a cumulative volume of 50 vol%, $D_{SEM50}$, as determined using the following measurement method. Specifically, observation images of the copper particles are obtained under a scanning electron microscope at a magnification in a range of 10,000x or more and 150,000x or less; in the observation images, 50 or more copper particles (primary particles) with well-defined contours are selected; the Heywood diameter is measured for each of the selected particles; the volumes of the particles are calculated from the Heywood diameters, assuming that the particles have a perfect spherical shape; and the cumulative volume particle size at a cumulative volume of 50 vol% in the volumes obtained from the calculation is determined, which is designated as $D_{SEM50}$.

The $D_{SEM50}$ of the copper powder composed of spherical copper particles is preferably 60 nm or more and 300 nm or less. When the $D_{SEM50}$ is in the range described above, excessive sintering of the copper paste and breakage of a resulting sintered body are suppressed, for example, and the strength and the shape retention of the sintered body are improved. In view of enhancing this effects even further, the $D_{SEM50}$ of the copper powder is more preferably 70 nm or more and 270 nm or less, and even more preferably 80 nm or more and 250 nm or less.

In a case where the two or more copper powders contain two types of spherical copper particles, the $D_{SEM50}$ of the spherical copper particles having the smaller $D_{SEM50}$ is preferably in the above-described range, and the $D_{SEM50}$ of the spherical copper particles having the larger $D_{SEM50}$ is preferably 1 $\mu$m or more and 10 $\mu$m or less.

When a copper powder is composed of non-spherical copper particles, the particle size of the copper powder is defined as a cumulative volume particle size $D_{50}$ at a cumulative volume of 50 vol% as determined by a laser diffraction scattering particle size distribution measurement method. For example, the determination can be performed in the following manner. Specifically, 0.1 g of a measurement sample and an aqueous solution containing a dispersing agent are mixed, and the mixture is subjected to dispersing treatment for 1 minute using an ultrasonic homogenizer (US-300T, manufactured by Nihonseiki Kaisha, Ltd.); then, a particle size distribution is determined using a laser diffraction scattering particle size distribution analyzer (for example, MT3300 EX II manufactured by Microtrac BEL Corporation); and thus, $D_{50}$ is calculated.

The $D_{50}$ of the copper powder composed of non-spherical copper particles is preferably 0.1 $\mu$m or more and 50 $\mu$m or less, more preferably 0.5 $\mu$m or more and 40 $\mu$m or less, and even more preferably 1 $\mu$m or more and 20 $\mu$m or less. In a case where the $D_{50}$ is within the range described above, a coating film formed of the copper paste tends to become a densely sintered bonding layer when fired, which results in a large bonding strength between bonding target members and improved electrical conduction reliability.

When the two or more copper powders contain two or more types of non-spherical copper particles as described above, it is preferable that the $D_{50}$'s of the non-spherical copper particles should be within the above-described range of $D_{50}$ but different from each other.

When the non-spherical copper particles are flat copper particles, their shape can be quantitatively expressed in the following manner.

Specifically, the ratio of the length of the major axis, a, to the length of the minor axis, b, of the flat copper particles (hereinafter this ratio will also be referred to as "aspect ratio (a/b)") is preferably 2 or more, and more preferably 5 or more. The aspect ratio is preferably 80 or less, and more preferably 40 or less.

The length of the major axis, a, of the flat copper particles is preferably 1 $\mu$m or more and 50 $\mu$m or less, more preferably 1.5 $\mu$m or more and 40 $\mu$m or less, and even more preferably 2 $\mu$m or more and 30 $\mu$m or less. In a case where the flat copper particles have such a shape, a coating film formed of the copper paste tends to become a densely sintered bonding layer when fired, which results in a large bonding strength between bonding target members and improved reliability of the bonded area.

The length of the major axis, a, and that of the minor axis, b, of the flat copper particles are determined in the following manner. From observation images of the flat copper particles under a scanning electron microscope at a magnification in a range of 500x or more and 50,000x or less, an image of a flat copper particle with a well-defined contour is obtained and subjected to image analysis. Specifically, while the flat copper particle is rotated 360 degrees in a direction horizontal to the planar surfaces thereof, imaginary circumscribed rectangles of two-dimensional projection images of the particle are drawn, and the longer side of a circumscribed rectangle that has the longest side among the circumscribed rectangles is used as the major axis. On the other hand, while the target particle is rotated 360 degrees in a direction perpendicular to the planar surfaces thereof, imaginary circumscribed rectangles of two-dimensional projection images of the particle are drawn, and the shorter side of a circumscribed rectangle whose longer side is the longest among the sides of the circumscribed rectangles is used as the minor axis. In the above-described manner, 50 or more flat copper particles are randomly selected, and for each of the selected particles, the length of the major axis, a, and the length of the minor axis, b, are determined. Then, the arithmetic mean value of the found lengths are obtained for each of the lengths a and b. For image analysis, image analyzing particle size distribution measurement software Mac-View manufactured by Mountech Co., Ltd. is used, for example.

When the copper powders contained in the copper paste of the present invention include the spherical copper particles and the non-spherical copper particles, the copper powders are preferably composed of a copper powder having a $D_{SEM50}$ of 60 nm or more and 300 nm or less (first copper powder) and a copper powder having a $D_{50}$ of 0.1 $\mu$m or more and 50 $\mu$m or less (second copper powder). The $D_{SEM50}$ and the $D_{50}$ are as described above.

When the copper paste of the present invention contains the first copper powder having a $D_{SEM50}$ of 60 nm or more and 300 nm or less, excessive sintering of the copper paste and breakage of a resulting sintered body are suppressed, and the strength and the shape retention of the sintered body are thus improved. When the copper paste of the present invention contains the second copper powder having a $D_{50}$ of 0.1 $\mu$m or more and 50 $\mu$m or less, the copper paste has improved sinterability, and the strength of a sintered body obtained through firing can be improved.

In particular, it is preferable that the first copper powder should be composed of spherical copper particles and that the second copper powder should be composed of flat copper particles, because this can improve the sinterability of the copper paste even further and also improve the bonding strength between a sintered body obtained through firing and a bonding target member even further.

In view of improving sinterability, the copper powder contained in the copper paste of the present invention preferably has controlled crystallinity. The degree of crystallinity of the copper powder can be evaluated in terms of the crystallite size as a measure. Specifically, regarding the crystallite size of the copper particles constituting the copper powder, the crystallite size in the (111) plane is preferably 100 nm or less, more preferably 70 nm or less, and even more preferably 50 nm or less. When the crystallite size is within this range, sintering occurs at a low temperature when the copper paste containing the copper powder is fired, and thus, the bonding strength between the resulting sintered body and a bonding target member can be easily improved.

At least one of the two or more copper powders contained in the copper paste of the present invention preferably has a crystallite size ratio E/D of 1.1 or greater, and more preferably 1.2 or greater, wherein D and E represent the crystallite size at 100°C and at 300°C, respectively, as determined by high-temperature X-ray diffractometry.

When the ratio E/D is 1.1 or greater, the copper particles exhibit high sinterability during heat treatment, ensuring a sufficient strength between the sintered body and the bonding target member.

The aforementioned crystallite sizes of the copper particles are each determined by analyzing an X-ray diffraction pattern obtained by XRD based on high-temperature XRD (powder X-ray diffractometry) and then performing calculation using the Scherrer's equation.

High-temperature XRD refers to a method in which a sample is placed in a high-temperature unit capable of heating a sample, and XRD is performed while gradually heating the sample. XRD is performed by using a fully automated horizontal multipurpose X-ray diffractometer manufactured by Rigaku Corporation and, as a detector, a high-speed 2D X-ray detector PILATUS 100K/R manufactured by Rigaku Corporation. The conditions for obtaining the X-ray diffraction pattern are as follows.

Optical system: Parallel beam
X-ray source: CuK$\alpha$ radiation
Measurement mode: Still mode 2$\theta$ = 42° fixed (X-ray diffraction intensities corresponding to 2$\theta$ = 38° to 48° can be obtained by the above 2D detector)
Exposure time: 60 seconds
Collimator: $\Phi$ 0.2 mm
Measurement atmosphere: Nitrogen
Measurement temperature: 100°C, 300°C
Rate of temperature increase: 10°C/min
During XRD (exposure time: 60 seconds) at each measurement temperature, the measurement temperature is maintained without temperature increase.

Next, the crystallite size is calculated, using the Scherrer's equation, from the half-width of an X-ray diffraction pattern of the (111) crystal plane of the copper particles obtained by the XRD described above.

$$\text{Scherrer's equation: } D = K\lambda/\beta\cos\theta$$

D: Crystallite size
K: Scherrer constant (0.94)
$\lambda$: Wavelength of X-ray
$\beta$: Half-width [rad]
$\theta$: Bragg angle [rad]

In a case where the two or more copper powders contained in the copper paste of the present invention include spherical copper particles having a $D_{SEM50}$ of 60 nm or more and 300 nm or less and non-spherical copper particles having

a $D_{50}$ of 0.1 $\mu$m or more and 50 $\mu$m or less, at least one of the spherical copper particles and the non-spherical copper particles preferably satisfies the aforementioned E/D, and more preferably, both of the spherical copper particles and the non-spherical copper particles satisfy the aforementioned E/D.

Examples of the copper powder having crystallinity as described above include CH-0200 and CH-0200L1 manufactured by Mitsui Mining & Smelting Co., Ltd.

The copper particles constituting the copper powder contained in the copper paste may have an organic surface treatment agent applied to their surfaces. The organic surface treatment agent is a treatment agent for preventing excessive aggregation and oxidation of copper particles. Examples of organic surface treatment agents suitably used in the present invention for this purpose include various fatty acids, aliphatic amines, and complexing agents having affinity for copper. In particular, it is preferable to use a saturated or unsaturated fatty acid or aliphatic amine having 6 to 18 carbon atoms, or more particularly 10 to 18 carbon atoms, in view of preventing excessive aggregation of copper particles.

Specific examples of such fatty acids or aliphatic amines include benzoic acid, pentanoic acid, hexanoic acid, octanoic acid, nonanoic acid, decanoic acid, lauric acid, palmitic acid, oleic acid, stearic acid, pentylamine, hexylamine, octylamine, decylamine, laurylamine, oleylamine, and stearylamine. Examples of the complexing agents having affinity for copper include amino acids such as glycine, and dimethylglyoxime. The fatty acids, the aliphatic amines, or the complexing agents may be used singly or in combination of two or more.

The ratio of the total mass of the two or more copper powders to the mass of the copper paste of the present invention (hereinafter also referred to as "ratio A" or simply "A") is preferably 0.60 or more and less than 0.82, more preferably 0.65 or more and 0.80 or less, and even more preferably 0.70 or more and 0.78 or less. When the ratio A is 0.60 or more, the copper paste has a viscosity adequate to apply the copper paste to a bonding target member, and the shape of the applied coating film can be favorably retained. When the ratio A is less than 0.82, bonding can be achieved with large strength and without uneven bonding, resulting from a synergistic effect with an index of bulkiness, H, which will be described later.

The copper powder contained in the copper paste can be produced using any of various methods known in the art. For example, the copper powder can be produced using a wet reduction method, an atomizing method, or an electrolytic method, for example. The method to be used can be appropriately selected according to the intended particle size, shape, and others of the copper powder.

Next, a solvent contained in the copper paste of the present invention will be described. As the solvent, any solvents conventionally used in the technical field of conductive compositions containing metal powder can be used without particular limitation. Examples of such solvents include monohydric alcohols, polyhydric alcohols, polyhydric alcohol alkyl ethers, polyhydric alcohol aryl ethers, polyethers, esters, nitrogen-containing heterocyclic compounds, amides, amines, terpene alcohols, ketones, and saturated hydrocarbons. These solvents may be used singly, or in combination of two or more thereof. Among these solvents, polyethers such as polyethylene glycol and polypropylene glycol and polyhydric alcohols such as ethylene glycol, propylene glycol, and hexylene glycol are preferably used because they are unlikely to cause side reactions during firing due to their low reactivity, and also sufficiently dissolve an additional component, which will be described later. For the same reasons, when polyethylene glycol is used as the solvent, the number average molecular weight thereof is preferably 600 or less.

The boiling point of the solvent is preferably 180°C or higher and 300°C or lower, more preferably 185°C or higher and 290°C or lower, and even more preferably 190°C or higher and 280°C or lower. When the solvent has a boiling point of 180°C or higher, the solvent will remain on a bonding target member for a sufficient period of time after the copper paste of the present invention is applied onto the bonding target member. This easily leads to an appropriate value of the index of bulkiness, H, which will be described later. On the other hand, when the solvent has a boiling point of 300°C or lower, the solvent can be easily removed by heating and drying, after the copper paste of the present invention has been applied onto the bonding target member.

In addition to the above-described two or more copper powders and solvent, the copper paste of the present invention may also contain additional components. Examples of the additional components include a binder component, a surface tension modifier, an anti-foaming agent, a viscoelasticity modifier, and a reducing agent. As for the content of the additional components, the total amount of the additional components is preferably 0.01 parts by mass or more and 10 parts by mass or less, and more preferably 0.1 parts by mass or more and 8 parts by mass or less, per 100 parts by mass of the copper powder.

As the reducing agent, those that promote sintering of the copper particles are preferable, and examples include monohydric alcohols, polyhydric alcohols, amino alcohols, citric acid, oxalic acid, formic acid, ascorbic acid, aldehyde, hydrazine and its derivatives, hydroxylamine and its derivatives, dithiothreitol, phosphite, hydrophosphite, and phosphorous acid and its derivatives.

The viscosity of the copper paste for pressure bonding can be measured using a Thermo Scientific MARS III rheometer. In view of enhancing the ease of application or printability of the copper paste for pressure bonding, the viscosity thereof is preferably 10 Pa·s or more and 200 Pa·s or less, and more preferably 15 Pa·s or more and 200 Pa·s or less, as measured at a shear rate of 10 s$^{-1}$. The conditions for measuring the viscosity of the copper paste for pressure bonding are as follows.

Measurement mode: Shear rate dependent measurement
Sensor: Parallel type ($\Phi$ 20 mm)
Measurement temperature: 25°C
Gap: 0.300 mm
Shear rate: 0.05 to 120.0 s$^{-1}$
Measurement time: 2 minutes

To adjusting the shear rate of the copper paste for pressure bonding to fall within the above range, the particle size of each copper powder, the concentration of the copper powders, and the type of the solvent, for example, can be appropriately adjusted or selected when mixing the copper powders and the solvent.

One of the features of the copper paste for pressure bonding of the present invention is a predetermined relationship between the content of the two or more copper powders in the copper paste, the film thickness of a coating film formed by applying the copper paste to a bonding target member, and the film thickness of a dried coating film formed by drying the coating film. More specifically, the ratio of the total mass of the two or more copper powders to the mass of the copper paste is represented by A, the film thickness of the coating film formed by applying the copper paste for pressure bonding at least containing the two or more copper powders and the solvent to a bonding target member is represented by B ($\mu$m), the film thickness of the dried coating film formed by drying the coating film at 110°C for 20 minutes in an air atmosphere is represented by C ($\mu$m), the index of bulkiness, H, is defined as H = C/(A×B), and H is preferably 0.75 or more and 1.00 or less.

When the copper paste for pressure bonding of the present invention having the above-described physical properties is applied to a bonding target member, such as a substrate, and then dried, a resulting dried coating film is a layer having a bulky structure like a cushioning material. When two bonding target members are pressure bonded to each other via such a dried coating film, the members can be sufficiently bonded to each other under smaller influence of variations in thickness of the bonding target members. As a result, for example, even when a bonding target member has a large area or when a thin bonding target member, such as a semiconductor element, is subjected to pressure bonding, bonding target members can be bonded to each other with good adhesion and high stability without damaging the bonding target members, and a large bonding strength is also obtained.

The method for applying the copper paste for pressure bonding of the present invention is not particularly limited, and examples of the method include a screen printing method, a gravure printing method, a dispense printing method, a reverse coating method, and a doctor blade method.

The film thicknesses of the coating film before drying, i.e., the thickness B, and that after drying, i.e., the thickness C can be measured in the following manner.

For example, use of an interference microscope enables contactless measurement of the film thicknesses B and C under no influence of a change in film thickness otherwise caused by a probe that would be brought into contact with the coating film. Specifically, the copper paste for pressure bonding is applied to the center of a flat substrate (2 mm thick) so as to form a coating film with a size of 6 mm square. The film thickness of the coating film to be formed, i.e., the film thickness B, is not particularly limited, and, in general, the film thickness B is preferably 15 $\mu$m or more and 800 $\mu$m or less, more preferably 15 $\mu$m or more and 300 $\mu$m or less, and particularly preferably 15 $\mu$m or more and 150 $\mu$m or less.

The substrate with the coating film formed on one side thereof is scanned in a height direction from the surface of the substrate to the maximum height of the coating film using a non-contact surface profiler, and then, line profile analysis of the scan results is performed to determine the film thicknesses B and C of the coating film. Details of the measurement method will be described later in Examples.

An example of the method for adjusting the index of bulkiness, H, is appropriately selecting the type of copper particles. More specifically, the index of bulkiness, H, tends to increase when the copper paste contains flat copper particles and, furthermore, the index H tends to increase as the aspect ratio of the flat copper particles is increased. The index of bulkiness, H, can also be increased by changing the type of solvent to thereby intentionally aggregate the copper particles contained.

The film thickness of the dried coating film, C, is preferably 5 $\mu$m or more and 500 $\mu$m or less, more preferably 10 $\mu$m or more and 400 $\mu$m or less, even more preferably 15 $\mu$m or more and 300 $\mu$m or less, and particularly preferably 15 $\mu$m or more and 130 $\mu$m or less, provided that the film thickness C is smaller than the film thickness of the coating film before drying, i.e., the thickness B. The film thickness of the coating film before drying and that after drying can be adjusted as appropriate by, for example, changing the shape and content of the copper powders contained in the composition used for forming the film, the type and content of the solvent, and the type and content of additional components.

The reason why a temperature of 110°C and a time of 20 minutes are selected as conditions for drying the coating film when determining the index of bulkiness, H, is that under these conditions, the solvent effectively volatilizes while the oxidation of the bonding target member is suppressed.

The copper paste for pressure bonding of the present invention can be used for bonding of a bonding target member to another bonding target member. In particular, since a large bonding strength can be obtained by using the copper paste for pressure bonding of the present invention, the copper paste can be suitably used for bonding of a bonding target member having a large area or a thin bonding target member. For example, the copper paste can be used for bonding of a bonding target member that has a thickness of not more than 10 times the film thickness of the dried coating film, C. In view of making better use of the feature of the copper paste of the present invention, specifically, its suitability for use in bonding of a thin bonding target member, the thickness of the bonding target member is more preferably not more than 10 times, and particularly preferably not more than 8 times, the film thickness of the dried coating film, C. In view of ensuring a sufficient bonding strength, it is preferable to use the copper paste for bonding of a bonding target member having a thickness not less than 1 times the film thickness of the dried coating film, C.

Among possible bonding target members, a semiconductor element and a substrate can be bonded to each other with the copper paste of the present invention, namely, by die attach technology, to thereby form a semiconductor device. A method for producing a semiconductor device includes: providing a stack in which a bonding target member, the copper paste of the present invention, and another bonding target member are put in this order, and firing the copper paste while a pressure of 0.1 MPa or more is applied. In this production method, at least one of the bonding target members includes a semiconductor element. For example, one of the bonding target members is a semiconductor element, and the other is a substrate.

In particular, since the copper paste for pressure bonding of the present invention is suitable for bonding of a thin bonding target member as described above, the thickness of the semiconductor element to be bonded to the substrate is preferably 0.25 mm or less, more preferably 0.23 mm or less, and particularly preferably 0.20 mm or less. On the other hand, the thickness of the semiconductor element to be bonded to the substrate is preferably 0.03 mm or more in view of obtaining a sufficient bonding strength.

Since the copper paste for pressure bonding of the present invention can be suitably used for bonding of a bonding target member having a large area, the paste of the present invention can be used for substrate attach technology, for example. Specifically, a first substrate on which a semiconductor element having an area of more than 25 mm$^2$ is mounted can be bonded to a second substrate with the copper paste of the present invention to thereby obtain a semiconductor device. The area of the semiconductor element mounted on the first substrate is more preferably larger than 30 mm$^2$, in view of making good use of the feature of the copper paste of the present invention, specifically, its suitability for use in bonding of a bonding target member having a large area.

There is no particular limitation on the types of the first substrate and the second substrate. Generally, both the first substrate and the second substrate preferably contain metal in their surfaces to be bonded to each other. For example, a member having a surface made of metal can be used as at least one of the first substrate and the second substrate. As used herein, the term "metal" refers to a metal itself that does not form a compound with another element, or an alloy of two or more metals. Examples of such metals include copper, silver, gold, aluminum, palladium, nickel, and alloys formed from combinations of two or more thereof.

When at least one of the first substrate and the second substrate is a member having a surface made of metal, the surface made of metal may be made of one metal or two or more metals. In a case where the surface is made of two or more metals, the surface may be made of an alloy. Generally, the surface made of metal is preferably a plane, but may be a curved surface, if necessary.

Examples of the first substrate and the second substrate include an insulating substrate having a ceramic or aluminum nitride plate and a metal layer thereon, the layer made of metal such as copper. The second substrate may be a heat dissipating plate, and is preferably a heat dissipating plate.

The conditions for bonding two bonding target members to each other with the copper paste of the present invention are, for example, as follows.

The heating temperature is preferably 200°C or higher and 350°C or lower, more preferably 210°C or higher and 330°C or lower, and even more preferably 220°C or higher and 300°C or lower.

The pressure is preferably 0.1 MPa or more and 30 MPa or less, more preferably 1 MPa or more and 25 MPa or less, and even more preferably 3 MPa or more and 20 MPa or less.

The atmosphere may be an inert atmosphere, a reducing atmosphere, or an oxidizing atmosphere. Examples of the inert atmosphere include a nitrogen gas atmosphere, and a rare gas atmosphere, such as argon or neon. From an economical point of view, it is preferable to use a nitrogen gas atmosphere. Examples of the reducing atmosphere include a hydrogen gas atmosphere, and a hydrogen gas atmosphere diluted with an inert gas. Examples of the oxidizing atmosphere include an air atmosphere.

The heating time is preferably 0.5 minutes or longer and 20 minutes or shorter, and more preferably 1 minute or longer and 15 minutes or shorter, though it depends on the state of pressure application described above. The time duration of pressure application is preferably 0.5 minutes or longer and 20 minutes or shorter, and more preferably 1 minute or longer and 15 minutes or shorter.

In a bonded body obtained by using the copper paste of the present invention, for example, in the semiconductor device described above, the bonding strength between the two bonding target members is sufficiently large with less uneven bonding.

With respect to the foregoing embodiments, the present invention further discloses a copper paste for pressure bonding, a semiconductor device, a method for producing a copper paste for pressure bonding, and a method for producing a semiconductor device, as described below.

(1) A copper paste for pressure bonding, at least comprising: two or more copper powders having different shapes and/or particle sizes; and a solvent;

wherein the copper paste has a viscosity of 10 Pa·s or more and 200 Pa·s or less at 25°C,
A is 0.60 or more and less than 0.82, and
H is 0.75 or more and 1.00 or less,
wherein A represents a ratio of a total mass of the two or more copper powders to a mass of the copper paste, and H represents an index of bulkiness defined as H = C/(A×B),
wherein B represents a film thickness of a coating film formed by applying the copper paste to a member to be bonded, and
C represents a film thickness of a dried coating film formed by drying the coating film in an air atmosphere at 110°C for 20 minutes.

(2) The copper paste for pressure bonding as set forth in clause (1),

wherein the two or more copper powders having different shapes and/or particle sizes contain spherical copper particles and non-spherical copper particles,
the spherical copper particles have a cumulative volume particle size at a cumulative volume of 50 vol%, $D_{SEM50}$, of 60 nm or more and 300 nm or less, as determined by image analysis using a scanning electron microscope, and
the non-spherical copper particles have a cumulative volume particle size at a cumulative volume of 50 vol%, $D_{50}$, of 0.1 $\mu$m or more and 50 $\mu$m or less, as determined by a laser diffraction scattering particle size distribution measurement method.

(3) The copper paste for pressure bonding as set forth in clause (2),

wherein the non-spherical copper particles are flat copper particles, and
the flat copper particles have a length of a major axis, a, of 1 $\mu$m or more and 50 $\mu$m or less, as determined by image analysis using a scanning electron microscope.

(4) The copper paste for pressure bonding as set forth in clause (2) or (3),

wherein the non-spherical copper particles are flat copper particles, and
the flat copper particles have an aspect ratio of 2 or more and 80 or less.

(5) The copper paste for pressure bonding as set forth in any one of clauses (1) to (4),
wherein at least one of the two or more copper powders has a crystallite size ratio E/D of 1.1 or greater, wherein D represents a crystallite size at 100°C and E represent a crystallite size at 300°C, as determined by high-temperature X-ray diffractometry.

(6) The copper paste for pressure bonding as set forth in any one of clauses (1) to (5), wherein the copper paste is used for bonding of a member to be bonded having a thickness of not more than 10 times the film thickness of the dried coating film, C.

(7) The copper paste for pressure bonding as set forth in any one of clauses (1) to (6),
wherein the solvent has a boiling point of 180°C or higher.

(8) A semiconductor device including: a semiconductor element having a thickness of 0.25 mm or less, and a substrate; wherein the semiconductor element and the substrate are bonded to each other with the copper paste for pressure bonding as set forth in any one of clauses (1) to (7).

(9) A semiconductor device including: a first substrate on which a semiconductor element having an area of more than 25 mm$^2$ is mounted, and a second substrate; wherein the first substrate and the second substrate are bonded to each other with the copper paste for pressure bonding as set forth in any one of clauses (1) to (7).

(10) A method for producing a semiconductor device,

the method including:

providing a stack in which a member to be bonded, the copper paste for pressure bonding as set forth in any one of clauses (1) to (7), and another member to be bonded are put in this order, and

firing the copper paste for pressure bonding while a pressure of 0.1 MPa or more is applied;

wherein at least one of the members to be bonded includes a semiconductor element.

(11) A method for producing a copper paste for pressure bonding,

the method comprising: mixing two or more copper powders having different shapes and/or particle sizes, and a solvent,

wherein the mixing step is regulated such that the copper paste has a viscosity of 10 Pa·s or more and 200 Pa·s or less at a shear rate of 10 s$^{-1}$, and

the mixing step is further regulated such that A is 0.60 or more and less than 0.82, and H is 0.75 or more and 1.00 or less,

wherein A represents a ratio of a total mass of the two or more copper powders having different shapes and/or particle sizes to a mass of the copper paste, and

H represents an index of bulkiness defined as H = C/(A×B),

wherein B represents a film thickness of a coating film formed by applying the copper paste to a member to be bonded, and

C represents a film thickness of a dried coating film formed by drying the coating film in an air atmosphere at 110°C for 20 minutes.

Examples

Hereinafter, the present invention will be described in further detail by way of Examples, but the scope of the present invention is not limited thereto.

Example 1

Preparation of Copper Paste

A copper powder 1 (copper powder composed of spherical copper particles having a $D_{SEM50}$ of 0.14 $\mu$m) and a copper powder 2 (copper powder composed of flat copper particles having a $D_{50}$ of 7.1 $\mu$m, a length of the major axis a of 6.2 $\mu$m, and an aspect ratio of 22) were mixed at a ratio of copper powder 1: copper powder 2 = 70:30 (by mass) to obtain a copper powder mixture. The copper powder mixture, a reducing agent (bis(2-hydroxyethyl)iminotris(hydroxymethyl) methane (hereinafter also referred to as "BIS-TRIS"), as an amino alcohol), and solvents (polyethylene glycol 300 and hexylene glycol) were mixed to prepare a copper paste. The mixing ratio between these components was as shown in Table 1. The ratio E/D of the copper powder 1 was 1.1. The ratio E/D of the copper powder 2 was 1.0.

In the prepared copper paste, the ratio of the mass of the copper powder mixture to the mass of the copper paste, i.e., the ratio A, was 0.76. The viscosity of the copper paste at a shear rate of 10 s$^{-1}$ was 33 Pa·s at 25°C.

Production of Bonded Structure

The copper paste was applied, by screen printing, to the center of a copper substrate (2 mm thick) for packaging to form a square printed coating film with a size of 6 mm square (hereinafter, the resultant will also be referred to as "substrate having a printed coating film"). This coating film was dried in an air atmosphere at 110°C for 20 minutes to remove the liquid medium, to thereby obtain a dried coating film (hereinafter the resultant will also be referred to as "substrate having a dried coating film").

Then, a silicon chip (5 mm × 5 mm, 0.2 mm thick; having a silver-plating layer serving as a surface to which the copper paste was to be adhered) was placed on the dried coating film. In this state, a pressure of 15 MPa was applied, and firing was performed in a nitrogen atmosphere at 300°C for 10 minutes, to thereby obtain a bonded structure.

Example 2

A copper paste was produced in the same manner as in Example 1 except the following: as the copper powder 2, a copper powder composed of flat copper particles having a $D_{50}$ of 4.9 $\mu$m, a length of the major axis, a, of 4.5 $\mu$m, and an aspect ratio of 13 was used (E/D of the copper powder 2 was 1.0); diethylene glycol dibutyl ether was added as a solvent; and the contents of the solvents (amounts per 100 parts by mass of the copper powder mixture) were changed as shown in Table 1. The viscosity of the copper paste at a shear rate of 10 s$^{-1}$ was 19 Pa·s at 25°C. Then, a dried coating film and a bonded structure were prepared in the same manner as in Example 1.

Comparative Example 1

A copper paste was prepared in the same manner as in Example 1, except that the copper powder 2 was changed to a copper powder composed of flat copper particles having a $D_{50}$ of 4.9 $\mu$m, a length of the major axis, a, of 4.5 $\mu$m, and an aspect ratio of 13, and that the contents of the solvents (amounts per 100 parts by mass of the copper powder mixture) were changed as shown in Table 1. The ratio of the mass of the copper powder mixture to the mass of the copper paste, i.e., the ratio A, was 0.82, and the viscosity of the copper paste for pressure bonding at a shear rate of 10 s$^{-1}$ was 28 Pa·s at 25°C. Then, a dried coating film and a bonded structure were prepared in the same manner as in Example 1.

Comparative Example 2

A copper paste was prepared in the same manner as in Example 1, except that the copper powder 2 was changed to a copper powder composed of flat copper particles having a $D_{50}$ of 4.9 $\mu$m, a length of the major axis a of 4.5 $\mu$m, and an aspect ratio of 13. The viscosity of the copper paste for pressure bonding at a shear rate of 10 s$^{-1}$ was 10 Pa·s at 25°C. Then, a dried coating film and a bonded structure were prepared in the same manner as in Example 1.

Evaluation of Bulkiness

For each of Examples and Comparative Examples, the film thickness of the printed coating film, B, and the film thickness of the dried coating film, C, were measured using a non-contact surface profiler (ZeGage Pro manufactured by Zygo Corporation). Observation was made in a field of view for measurement of 13.9 mm × 10.4 mm using an objective lens having a magnification of 1.4x and a zoom lens having a magnification of 1.0x, and the film thickness of each coating film was determined from the difference in height between the surface of the coating film and the surface of the substrate.

More specifically, after selecting the measurement mode, a measurement target (the substrate having a printed coating film or the substrate having a dried coating film of each of Examples and Comparative Examples) was mounted on a stage, and the position thereof was adjusted in the longitudinal and lateral directions such that the coating film was positioned at substantially the center. Then, the objective lens was moved in the height direction to focus on the surface of the substrate. The start position of scan in the height direction was set to Bottom and the scan length to 500 $\mu$m. Then, measurement was carried out horizontally at 6.3-$\mu$m intervals in the longitudinal and lateral directions.

The results obtained were subjected to line profile analysis. The line was drawn on a diagonal line of the coating film so as to include, at both ends thereof, about 1 mm of the substrate surface (regions where the coating film was not applied). The two ends of the line was leveled with each other to achieve parallelism of the substrate surface. The film thickness of the coating film was obtained from the difference in height between the surface of the coating film and the substrate surface. The height of the substrate surface was measured at the position 0.5 mm away from the end of the coating film. The height of the surface of the coating film was measured at the center point of the coating film, and the center point was the intersection of two diagonal lines drawn on the square coating film. The index of bulkiness, H, was calculated from the found film thickness of the printed coating film, B, and film thickness of the dried coating film, C, and also the ratio of the total mass of the copper powders in the copper paste (i.e., the ratio A), using the following equation: H = C/(A×B).

For each of Examples and Comparative Examples, the found values of the film thicknesses B and C and the index of bulkiness, H, are shown in Table 2.

Evaluation of Bonding Rate of Sintered Copper to Chip

For each of the bonded structures produced in Examples and Comparative Examples, a bonding interface between the chip and the sintered copper was analyzed horizontally at 20-$\mu$m intervals in the longitudinal and lateral directions by a reflection method using an ultrasonic imaging apparatus (FineSAT F300 III from Hitachi High-Tech Corporation) with a 75 MHz probe, to thereby obtain a scanning acoustic tomography image (SAT image). When observing the state of the delamination of the bonding layer, the gain value was set to a value between 25 and 35 dB, and the delay and width of the S-gate were adjusted so that the peak position of the S-gate was at the surface of the copper substrate. The delay of the F-gate was adjusted to specify the observation range of the bonding layer, and the width thereof was set to a peak width of 1.5 wavelengths. The Z-axis coordinates of the probe were adjusted to maximize the amplitude of the observation peak, and observation was carried out. The contrast of the observation image was adjusted using the auto function.

In the obtained SAT image, an area corresponding to the chip-bonded region was binarized using image processing software (Image J), and the percentage of a black area in the observation area (bonding rate; %) was calculated. More specifically, after starting Image-J, "Analyze"-"Set measurement" was selected, and "Area", "Area fraction", "Limit to Threshold" were checked. Next, "File"-"Open" was selected, and image data for calculating the bonding rate was opened. Then, the range of the area where the silicon chip was mounted (hereinafter also referred to as "the range (A)") in the image was specified. Next, "Edit"-"Copy to system" was selected, and the range (A) was copied. Then, "File"-"New"-"System clipboard" was selected, and an image of the specified range (A) was pasted. Subsequently, in order to clarify the bonded area, "Image"-"Type"-"8 bit" was selected to convert the image, and then, "Image"-"Adjust"-"Threshold" was selected to adjust the threshold of the image to 100. Then, the black range (B) present in the range (A), which was the area where the silicon chip was mounted, in the resulting image was specified. The black range (B) was the range where the threshold value was 100 or less, and can be regarded as a silicon chip-bonded area. The bonding rate (%) was calculated from a formula: area of (B)/ area of (A) × 100. For each of Examples and Comparative Examples, the found bonding rate (%) is shown in Table 2.

Table 1

| | Composition of copper paste | | | | | | | Viscosity at 10 s$^{-1}$, 25°C (Pa·s) |
| | Copper powder mixture | | | Reducing agent | | Solvent | | |
| | Copper powder 1 | Copper powder 2 | Content (parts by mass) | Type | Content (parts by mass) | Type | Content (parts by mass) | |
| Ex. 1 | Spherical (70 mass% in mixture) | Flat (30 mass% in mixture) | 100 | BIS-TRIS | 0.1 | Polyethylene glycol 300 | 1.9 | 33 |
| | | | | | | Hexylene glycol | 29.6 | |
| Ex. 2 | Spherical (70 mass% in mixture) | Flat (30 mass% in mixture) | 100 | BIS-TRIS | 0.1 | Polyethylene glycol 300 | 1.9 | 19 |
| | | | | | | Hexylene glycol | 20 | |
| | | | | | | Diethylene glycol dibutyl ether | 9.6 | |
| Com. Ex. 1 | Spherical (70 mass% in mixture) | Flat (30 mass% in mixture) | 100 | BIS-TRIS | 0.1 | Polyethylene glycol 300 | 1.9 | 28 |
| | | | | | | Hexylene glycol | 20 | |
| Com. Ex. 2 | Spherical (70 mass% in mixture) | Flat (30 mass% in mixture) | 100 | BIS-TRIS | 0.1 | Polyethylene glycol 300 | 1.9 | 10 |
| | | | | | | Hexylene glycol | 29.6 | |

Table 2

| | Mass ratio of copper powders to copper paste A | Film thickness of printed coating film B (μm) | Film thickness of dried coating film C (μm) | Index of bulkiness H | Bonding rate (%) |
| --- | --- | --- | --- | --- | --- |
| Ex. 1 | 0.76 | 116 | 82 | 0.93 | 98.1 |
| Ex. 2 | 0.76 | 113 | 66 | 0.76 | 97.9 |
| Com. Ex. 1 | 0.82 | 123 | 86 | 0.85 | 29.1 |
| Com. Ex. 2 | 0.76 | 109 | 58 | 0.70 | 18.1 |

The results shown in Table 2 clearly indicate that each bonded body produced by using the copper paste obtained in Example had large bonding strength between the bonding target members though the bonding target members were thin or had a large area.

Industrial Applicability

According to the present invention, there is provided a copper paste for pressure bonding which enables bonding with large strength without uneven bonding even when a bonding target member is thin or has a large area.

**Claims**

1. A copper paste for pressure bonding, at least comprising: two or more copper powders having different shapes and/or particle sizes; and a solvent;

   wherein the copper paste has a viscosity of 10 Pa·s or more and 200 Pa·s or less at 25°C,
   A is 0.60 or more and less than 0.82, and
   H is 0.75 or more and 1.00 or less,
   wherein A represents a ratio of a total mass of the two or more copper powders to a mass of the copper paste, and H represents an index of bulkiness defined as $H = C/(A \times B)$,
   wherein B represents a film thickness of a coating film formed by applying the copper paste to a member to be bonded, and
   C represents a film thickness of a dried coating film formed by drying the coating film in an air atmosphere at 110°C for 20 minutes.

2. The copper paste for pressure bonding according to claim 1,

   wherein the two or more copper powders having different shapes and/or particle sizes contain spherical copper particles and non-spherical copper particles,
   the spherical copper particles have a cumulative volume particle size at a cumulative volume of 50 vol%, $D_{SEM50}$, of 60 nm or more and 300 nm or less, as determined by image analysis using a scanning electron microscope, and
   the non-spherical copper particles have a cumulative volume particle size at a cumulative volume of 50 vol%, $D_{50}$, of 0.1 $\mu$m or more and 50 $\mu$m or less, as determined by a laser diffraction scattering particle size distribution measurement method.

3. The copper paste for pressure bonding according to claim 2,

   wherein the non-spherical copper particles are flat copper particles, and
   the flat copper particles have a length of a major axis, a, of 1 $\mu$m or more and 50 $\mu$m or less, as determined by image analysis using a scanning electron microscope.

4. The copper paste for pressure bonding according to claim 2 or 3,

   wherein the non-spherical copper particles are flat copper particles, and
   the flat copper particles have an aspect ratio of 2 or more and 80 or less.

5. The copper paste for pressure bonding according to any one of claims 1 to 3, wherein at least one of the two or more copper powders has a crystallite size ratio E/D of 1.1 or greater, wherein D represents a crystallite size at 100°C and E represents a crystallite size at 300°C, as determined by high-temperature X-ray diffractometry.

6. The copper paste for pressure bonding according to any one of claims 1 to 3, wherein the copper paste is used for bonding a member to be bonded having a thickness of not more than 10 times the film thickness of the dried coating film, C.

7. The copper paste for pressure bonding according to any one of claims 1 to 3, wherein the solvent has a boiling point of 180°C or higher.

8. A semiconductor device comprising: a semiconductor element having a thickness of 0.25 mm or less, and a substrate; wherein the semiconductor element and the substrate are bonded to each other with the copper paste for pressure bonding according to any one of claims 1 to 3.

9. A semiconductor device comprising: a first substrate on which a semiconductor element having an area of more than 25 mm$^2$ is mounted, and a second substrate; wherein the first substrate and the second substrate are bonded to each other with the copper paste for pressure bonding according to any one of claims 1 to 3.

10. A method for producing a semiconductor device,

   the method comprising:

   providing a stack in which a member to be bonded, the copper paste for pressure bonding according to any one of claims 1 to 3, and another member to be bonded are put in this order, and
   firing the copper paste for pressure bonding while a pressure of 0.1 MPa or more is applied;

   wherein at least one of the members to be bonded includes a semiconductor element.

11. A method for producing a copper paste for pressure bonding,

   the method comprising: mixing two or more copper powders having different shapes and/or particle sizes, and a solvent,
   wherein the mixing step is regulated such that the copper paste has a viscosity of 10 Pa·s or more and 200 Pa·s or less at a shear rate of 10 s$^{-1}$, and
   the mixing step is further regulated such that A is 0.60 or more and less than 0.82, and H is 0.75 or more and 1.00 or less,
   wherein A represents a ratio of a total mass of the two or more copper powders having different shapes and/or particle sizes to a mass of the copper paste, and
   H represents an index of bulkiness defined as H = C/(A×B),
   wherein B represents a film thickness of a coating film formed by applying the copper paste to a member to be bonded, and
   C represents a film thickness of a dried coating film formed by drying the coating film in an air atmosphere at 110°C for 20 minutes.

| | INTERNATIONAL SEARCH REPORT | International application No. |
|---|---|---|
| | | **PCT/JP2023/007403** |

## A. CLASSIFICATION OF SUBJECT MATTER

*H01B 1/22*(2006.01)i; *B22F 1/00*(2022.01)i; *B22F 1/052*(2022.01)i; *B22F 1/06*(2022.01)i; *B22F 1/107*(2022.01)i;
*B22F 7/08*(2006.01)i; *B22F 9/00*(2006.01)i; *H01L 21/52*(2006.01)i
FI: H01B1/22 A; B22F1/06; B22F1/052; B22F7/08 C; B22F1/00 L; B22F1/107; H01L21/52 C; B22F9/00 B

According to International Patent Classification (IPC) or to both national classification and IPC

## B. FIELDS SEARCHED

Minimum documentation searched (classification system followed by classification symbols)

H01B1/22; B22F1/00; B22F1/052; B22F1/06; B22F1/107; B22F7/08; B22F9/00; H01L21/52

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| X | WO 2020/203530 A1 (MITSUI MINING & SMELTING CO., LTD.) 08 October 2020 (2020-10-08) paragraphs [0001]-[0082] | 1-4, 6-11 |
| Y | | 5 |
| Y | JP 2019-2054 A (MITSUI MINING & SMELTING CO., LTD.) 10 January 2019 (2019-01-10) paragraphs [0012]-[0062] | 5 |
| A | JP 2020-32657 A (HITACHI CHEMICAL CO., LTD.) 05 March 2020 (2020-03-05) paragraphs [0001]-[0121] | 1-11 |

☐ Further documents are listed in the continuation of Box C.     ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **18 April 2023** | **09 May 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
Information on patent family members

International application No.

**PCT/JP2023/007403**

| Patent document cited in search report | | | Publication date (day/month/year) | Patent family member(s) | | | Publication date (day/month/year) |
|---|---|---|---|---|---|---|---|
| WO | 2020/203530 | A1 | 08 October 2020 | US 2022/0118546 A1 paragraphs [0001]-[0090] EP 3950185 A1 CN 113412171 A KR 10-2021-0125995 A TW 202110555 A MY 194637 A | | | |
| JP | 2019-2054 | A | 10 January 2019 | (Family: none) | | | |
| JP | 2020-32657 | A | 05 March 2020 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3950185 A1